# EUROPEAN PATENT APPLICATION

(11) **EP 4 380 144 A1**
(43) Date of publication of application: **05.06.2024**
(21) Application number: 22848935.7
(22) Date of filing: 28.03.2022
(51) Int. Cl.: H04N 5/64

(54) **DISPLAY DEVICE AND STAND**

(30) Priority: 28.07.2021 JP 2021122903
(71) Applicant: Panasonic Intellectual Property Management Co., Ltd., Osaka-shi, Osaka 540-6207 (JP)
(72) Inventor: HONDA, Kazuya, Osaka-shi, Osaka 540-6207 (JP); UENO, Tatsuro, Osaka-shi, Osaka 540-6207 (JP); NAKAMOTO, Senri, Osaka-shi, Osaka 540-6207 (JP)
(74) Representative: Novagraaf International SA
(86) International application number: PCT/JP2022/014857
(87) International publication number: WO 2023/007852

(57) **Abstract**

A display device (100) includes a body (10) that displays an image and a base (22) that supports the body (10) in a state where the base is placed on a floor surface. The base (22) includes a plurality of casters (23) that roll on the floor surface. The plurality of casters (23) include at least one first caster (231) and at least one second caster (232) having a hardness lower than a hardness of the first caster.

## Description

### [Technical Field]

The present invention relates to a display device and a stand.

### [Background Art]

For example, Patent Literature (PTL) 1 discloses a technique to enhance the mobility of a display device by holding the display device using a stand that includes casters.

### [Citation List]

### [Patent Literature]

[PTL 1] Japanese Unexamined Patent Application Publication No. 2021-93637

### [Summary of Invention]

### [Technical Problem]

Recent years have seen the development of techniques in which a tuner device and a display device are provided separately, and broadcast signals are transmitted wirelessly from the tuner device to the display device. In such cases, since there is no need for an antenna cable, the degree of freedom of movement is enhanced, and the display device may be moved more frequently than in the past. Here, when the hardness of each caster is high, rolling noise will be louder. On the other hand, when the hardness of each caster is low, casters will become deformed (creep deformation) if left alone for extended periods of time, thereby resulting in reduced stability while in motion.

An object of the present invention is to provide a display device and a stand that are capable of inhibiting caster deformation while suppressing rolling noise.

### [Solution to Problem]

A display device according to one aspect of the present invention includes a body that displays an image and a base that supports the body in a state where the base is placed on a floor surface. The base includes a plurality of casters that roll on the floor surface, and the plurality of casters include at least one first caster and at least one second caster having a hardness lower than a hardness of the first caster.

A stand according to one aspect of the present invention is a stand that supports a display device and includes a base that holds the display device in a state where the base is placed on a floor surface. The base includes a plurality of casters that roll on the floor surface, and the plurality of casters include at least one first caster and at least one second caster having a hardness lower than a hardness of the first caster.

### [Advantageous Effects of Invention]

The present invention can provide a display device and a stand that are capable of inhibiting caster deformation while suppressing rolling noise.

### [Brief Description of Drawings]

[FIG. 1]

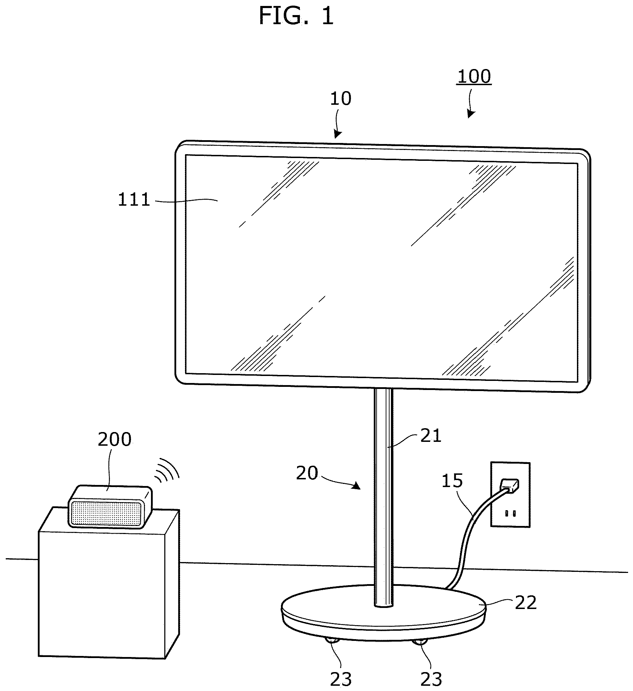

   FIG. 1 is a diagram for describing an outline configuration of a display device according to Embodiment 1.
[FIG. 2]

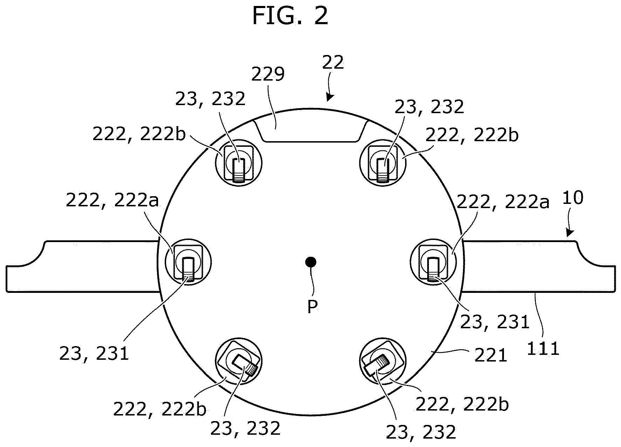

   FIG. 2 is a bottom view illustrating an outline configuration of the display device according to Embodiment 1.
[FIG. 3]

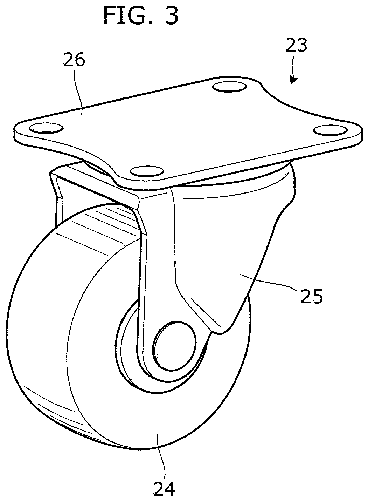

   FIG. 3 is a perspective view illustrating an outline configuration of the caster according to Embodiment 1.
[FIG. 4]

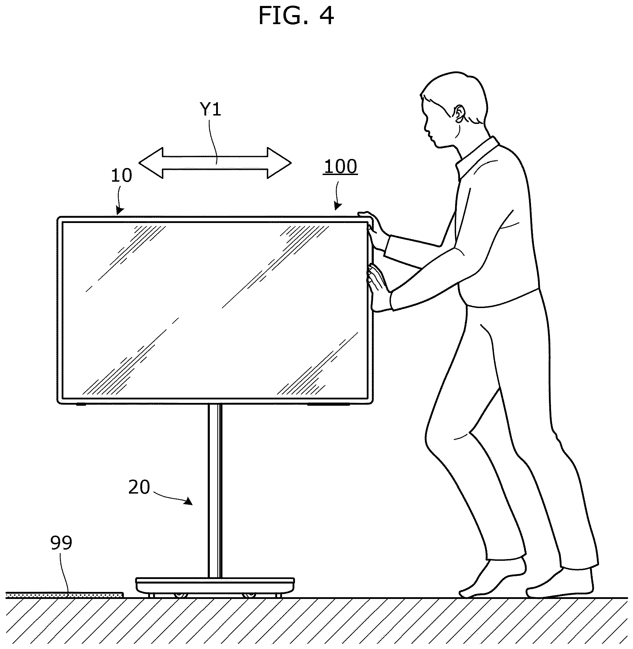

   FIG. 4 is a diagram for describing the display device according to Embodiment 1 in a state where the display device is being moved.
[FIG. 5]

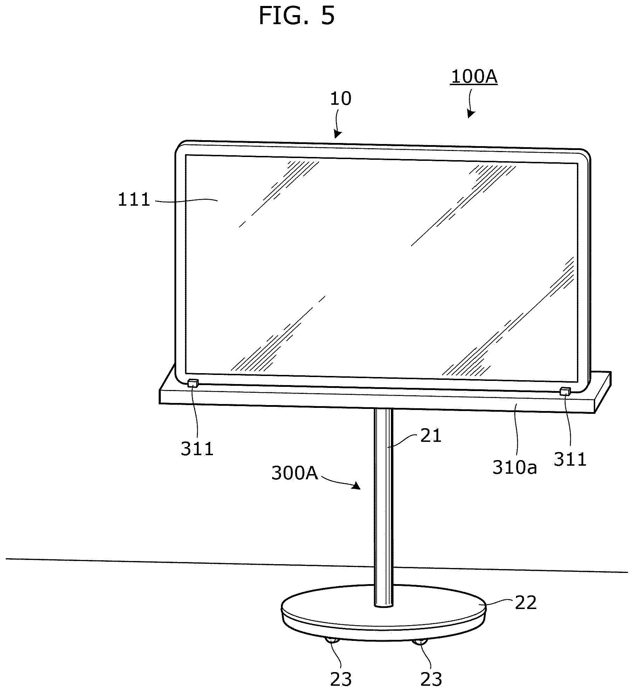

   FIG. 5 is a diagram for describing a display device and a stand according to Embodiment 2.
[FIG. 6]

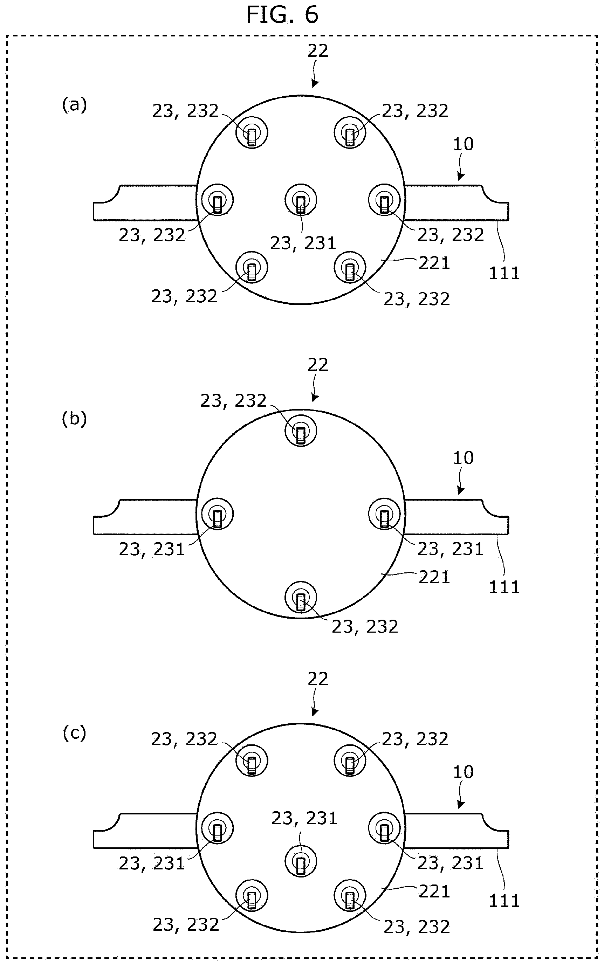

   FIG. 6 is a diagram for describing layout examples of first casters and second casters according to variations.

### [Description of Embodiments]

Hereinafter, embodiments of display devices, and the like, according to the present invention will be described in detail with reference to the drawings. It should be noted that the embodiments described below each illustrate a specific, preferred example of the present invention. Accordingly, the numerical values, shapes, materials, elements, arrangement and connection states of the elements, etc., described in the following embodiments are mere examples, and are therefore not intended to limit the present invention.

Note that the accompanying drawings and the following descriptions are provided not to limit the subject matter contained in the claims, but to aid those skilled in the art to adequately understand the present invention.

It should be noted that the respective figures are schematic diagrams and are not necessarily precise illustrations. Moreover, elements that are substantially the same are given the same reference signs in the respective figures, and redundant descriptions may be omitted or simplified.

### [Embodiment 1]

### [Display Device]

First, display device 100 according to Embodiment 1 will be described. FIG. 1 is a diagram for describing an outline configuration of display device 100 according to Embodiment 1. As illustrated in FIG. 1, display device 100 freely performs wireless communication with tuner device 200, which is a separate device from display device 100. Tuner device 200 receives a broadcast wave and generates a broadcast signal. Tuner device 200 generates a video signal for wireless transmission based on the broadcast signal and transmits the video signal wirelessly. Display device 100 is capable of receiving the video signal transmitted from tuner device 200 and displaying images based on the video signal. It should be noted that display device 100 may be a monitor device that performs wireless or wired communication with terminal devices, such as a personal computer (PC), smartphone, tablet device, and the like, and displays images.

Furthermore, display device 100 is a display device with an integrated stand. Specifically, display device 100 includes body 10 that displays images and stand 20 that supports body 10. Stand 20 includes a single column 21 that is connected to body 10 and supports body 10 from below, and base 22 that is placed on a floor surface and supports body 10 via column 21.

Column 21 stands vertically from approximately the central portion of the top surface of base 22. Specifically, the upper end of column 21 is fixed to body 10, and the bottom end of column 21 is fixed to base 22. Column 21 is placed at a position that overlaps center of gravity P (see FIG. 2) of body 10 in a bottom view, or a position in the vicinity of center of gravity P. Accordingly, base 22 is placed at a position that overlaps center of gravity P of body 10 in a plan view (bottom view) of base 22. Furthermore, in a bottom view, both side portions (ends) of body 10 protrude beyond base 22.

Wiring that supplies power to body 10 is provided inside of column 21. Although FIG. 1 illustrates an example of a cylindrical column 21, the column may be of any external shape. For example, other possible external shapes for the column include various elliptical discs, polygonal columns, and the like.

Next, base 22 will be described in detail. FIG. 2 is a bottom view illustrating an outline configuration of display device 100 according to Embodiment 1. As illustrated in FIG. 2, base 22 includes base body 221, which is circular in a bottom view, and a plurality of casters 23 that are provided on the bottom surface of base body 221.

Base body 221 is disc shaped, and storage section 229, which can be opened and closed and is used to store power cable 15, is placed on the bottom surface of base body 221. Furthermore, a plurality of recessed portions 222 are provided on the bottom surface of base body 221, and each of casters 23 are provided inside a different one of recessed portions 222. The plurality of recessed portions 222 are evenly arranged in a circumferential direction on the periphery of base body 221. In the present embodiment, six recessed portions 222 are provided, and it can be said that recessed portions 222 are disposed to coincide with the vertices of a virtual hexagon. Here, it should be noted that of the six recessed portions 222, two recessed portions 222a are arranged in a direction parallel to display surface 111 of body 10, in positions that overlap body 10 in a plan view of base 22. The two recessed portions 222a are arranged in the direction parallel to display surface 111 so that the other four recessed portions 222b are disposed therebetween. In other words, out of all recessed portions 222, the two recessed portions 222a are disposed at both ends in the direction parallel to display surface 111. Moreover, the two recessed portions 222a do not necessarily need to overlap body 10 in a plan view of base 22. The other four recessed portions 222b are disposed at positions in front of or behind of body 10. Furthermore, the other four recessed portions 222b are located further inwards in the widthwise direction (left-right direction) of body 10 than the two recessed portions 222a.

FIG. 3 is a perspective view illustrating an outline configuration of caster 23 according to Embodiment 1. As illustrated in FIG. 3, caster 23 includes wheel 24, support component 25 that supports wheel 24 to rotate freely, and base plate 26 that supports support component 25 to swivel freely. The axle of wheel 24 is supported at both ends by support component 25 to rotate freely. Although casters 23 have approximately the same structure, wheels 24 have different degrees of hardness. Hereinafter, the two casters 23, which are provided within the two recessed portions 222a will be referred to as first casters 231, and the four casters 23 provided within the other four recessed portions 222b will be referred to as second casters 232 (see FIG. 2).

The hardness of wheels 24 of second casters 232 is lower than the hardness of wheels 24 of first casters 231. Specifically, different materials are used to set the hardness of wheels 24 of first casters 231 and wheels 24 of second casters 232. For example, wheels 24 of first casters 231 are formed using nylon, while wheels 24 of second casters 232 are formed using elastomer or urethane. It should be noted that the materials described here are merely given as examples, and any materials may be used as long as a relationship where the hardness of wheels 24 of second casters 232 is lower than the hardness of wheels 24 of first casters 231 is satisfied. Furthermore, the structure of wheels 24 may be used to adjust hardness. For example, even when the same material is used to form wheels 24 of first casters 231 and wheels 24 of second casters 232, hardness may be adjusted by providing wheels 24 of first casters 231 with a denser structure and by providing wheels 24 of second casters 232 with a sparser structure. In this manner, the two first casters 231 having relatively high hardness are provided within the two recessed portions 222a as illustrated in FIG. 2, and are arranged in a direction parallel to display surface 111 so that the other four second casters 232 are disposed therebetween. Accordingly, the two first casters 231 are arranged in the direction parallel to display surface 111 of body 10, in positions that overlap body 10 in a plan view of base 22. Specifically, in a bottom view, both side portions of body 10 protrude beyond the two first casters 231.

### [Regarding Display Device Movement]

Next, movement related to display device 100 will be described. FIG. 4 is a diagram for describing display device 100 according to Embodiment 1 in a state where display device 100 is being moved. As illustrated in FIG. 4, the user grasps one side portion of body 10, and pushes toward the other side to move display device 100. Alternatively, the user grasps one side portion of body 10, and pulls it toward himself/herself to move display device 100 (see arrow Y1 in the figure). During movement, the two first casters 231 having high hardness and the four second casters 232 having low hardness roll on the floor surface. Accordingly, when compared to a case where all six casters are first casters 231, since fewer first casters 231 are provided, rolling noise can thereby be reduced. Furthermore, floor damage caused by first casters 231 having high hardness can be inhibited.

Moreover, since the two first casters 231 are arranged to overlap body 10 in a plan view of base 22, first casters 231 are subjected to a higher load compared to the four second casters 232. Accordingly, when hardness of the two first casters 231 is low, friction with the floor surface will be high, and the display device will tip over when traveling over surfaces uneven with the floor, such as carpet 99, or the like, or when turning, thereby resulting in unstable traveling performance. This is quite evident in the casters 23 that are disposed at the leading edge of the path of travel. However, in the present embodiment, since the hardness of the two first casters 231 is set higher than the hardness of second casters 232, friction with the floor surface is reduced, thereby making it possible to stabilize traveling performance. In particular, since the two first casters 231 are positioned at the leading edges of each of the paths of travel Y1, first casters 231 are suitable for stabilizing traveling performance.

Furthermore, in a case where the display device is at rest and it is assumed that all six of the casters are second casters 232, the deadweight of display device 100 will cause creep deformation of each of the second casters 232. In contrast, in the present embodiment, base body 221, column 21, and body 10 are supported by two first casters 231 having high hardness and four second casters 232 having low hardness. Since each first caster 231 has relatively high hardness, deformation is unlikely to occur. Furthermore, as long as each first caster 231 is able to maintain its original shape, load exerted on each second caster 232 having relatively low hardness will be reduced, thereby inhibiting deformation of each second caster 232. In other words, since deformation of each caster 23 is reduced, stable traveling performance can be maintained.

### [Advantageous Effects, Etc.]

As described above, display device 100 according to the embodiment includes body 10 that displays images and base 22, which is placed on a floor surface and supports body 10. Base 22 includes a plurality of casters 23 that roll on a floor surface. The plurality of casters 23 include at least one first caster 231 and at least one second caster 232 having a hardness lower than the hardness of first caster 231.

Accordingly, since the hardness of second caster 232 is lower than the hardness of first caster 231, rolling noise can be reduced when compared to a case where all casters 23 are first casters 231. At the same time, since first caster 231 has a hardness higher than the hardness of second caster 232, deformation of each caster 23 (first caster 231 and second caster 232) can be inhibited when compared to a case where all casters 23 are second casters 232. Consequently, it is possible to provide a display device 100 for which deformation of casters 23 can be inhibited while suppressing rolling noise.

Furthermore, the plurality of casters 23 are arranged in a circumferential direction on base 22, and two first casters 231 are provided, with the two first casters arranged in a direction parallel to display surface 111 of body 10, in positions that overlap body 10 in a plan view of base 22.

Accordingly, since two first casters 231 having high hardness are arranged in the direction parallel to display surface 111 of body 10, in positions that overlap body 10 in a plan view of base 22, stable traveling performance can be achieved when the display device is rolling over surfaces uneven with the floor or when turning.

Furthermore, base 22 is disposed in a position that overlaps center of gravity P of body 10 in a plan view of base 22. Both side portions of body 10 protrude beyond base 22 in a plan view of base 22.

Here, even when base 22 is disposed to overlap center of gravity P of body 10, if both side portions of body 10 protrude beyond base 22, the display device becomes prone to tipping over when rolling over surfaces uneven with the floor or when turning. Even for such forms of display device 100 that are prone to tipping over, traveling performance can be enhanced since first casters 231 and second casters 232 are provided.

Furthermore, display device 100 includes column 21 that stands in a manner extending from base 22 and supports body 10.

As described earlier, display device 100 according to the present embodiment achieves stable traveling performance by way of first casters 231 and second casters 232. If traveling performance is stabilized, the portion that connects body 10 and base 22 can be simplified. Accordingly, in the present embodiment, a simple design has been realized by using column 21 as the portion that connects body 10 and base 22.

### [Embodiment 2]

In Embodiment 1 as described above, an example is given of display device 100 with an integrated stand. In the present embodiment, an example is given of display device 100A and stand 300A, which are provided as separate units. In the following descriptions, portions that are equivalent to that of Embodiment 1 are given the same reference signs and descriptions thereof may be omitted.

FIG. 5 is a diagram for describing display device 100A and stand 300A according to Embodiment 2. As illustrated in FIG. 5, display device 100A is a portion that is equivalent to body 10 in Embodiment 1. Although stand 300A is a portion equivalent to stand 20 in Embodiment 1, stand 300A is originally provided as a unit separate from display device 100A, and display device 100A and stand 300A are integrated by placing display device 100A on stand 300A. Specifically, stand 300A includes column 21, base 22, and restricting component 310a. Restricting component 310a is fixed to the end of column 21 and extends in a horizontal direction. Restricting component 310a is formed in an elongated manner in a direction parallel to display surface 111 of display device 100A in a bottom view. Specifically, the lengthwise direction of restricting component 310a is a direction parallel to display surface 111. Display device 100A is placed on the top surface of restricting component 310a. Positioning tabs 311 that are used to position display device 100A are provided on the top surface of restricting component 310a. These positioning tabs 311 restrict the position of display device 100A so that the two first casters 231 of stand 300A are arranged in a direction parallel to display surface 111 of display device 100A, in positions that overlap display device 100A in a plan view of base 22.

Moreover, latching components, such as bolts, or the like, may be used to latch display device 100A onto restricting component 310a. In this case, it is assumed that the direction parallel to display surface 111 of display device 100A is the direction in which the two first casters 231 are lined up. In this case, the bottom surface of display device 100A may be fixed to restricting component 310a using latching components, and restricting component 310a may be of a shape that allows latching components to latch onto the rear surface of display device 100A. Furthermore, in this case, the lengthwise direction of the restricting component need not be parallel to the display surface, and the restricting component need not have an elongated shape.

### [Advantageous Effects, Etc.]

As described above, stand 300A that supports display device 100A includes base 22 which is placed on a floor surface and holds display device 100A. Base 22 includes a plurality of casters 23 that roll on the floor surface. The plurality of casters 23 include at least one first caster 231 and at least one second caster 232 having a hardness lower than the hardness of first caster 231.

Accordingly, since the hardness of second caster 232 is lower than the hardness of first caster 231, rolling noise can be reduced when compared to cases where all casters 23 are first casters 231. At the same time, since the hardness of first caster 231 is higher than the hardness of second caster 232, deformation can be inhibited for each caster 23 (first caster 231 and second caster 232) when compared to cases where all casters 23 are second casters 232. Consequently, it is possible to provide stand 300A capable of inhibiting deformation of casters 23 while suppressing rolling noise.

Furthermore, stand 300A includes restricting component 310a that restricts the position of display device 100A. A plurality of casters 23 are arranged in a circumferential direction on base 22. Two first casters 231 are provided. Restricting component 310a restricts the position of display device 100A to keep the two first casters 231 arranged in a direction parallel to display surface 111 of display device 100A, in positions that overlap display device 100A in a plan view of base 22.

Accordingly, since restricting component 310a causes two first casters 231 having high hardness to be arranged in the direction parallel to display surface 111 of body 10, in positions that overlap body 10 in a plan view of base 22, traveling performance when the display device is rolling over surfaces uneven with the floor or when turning can be stabilized.

### [Other Embodiments, Etc.]

Although the display device and stand according to the present invention have been described based on the above embodiments, the present invention is not limited to the above embodiments.

For example, in the above embodiments, a case where there is only a single column 21 connecting base 22 and body 10 is given as an example. However, two or more columns may be provided. For example, when a plurality of columns are provided, the body can be supported in a stable manner. Furthermore, the base and the body do not need to be connected using a column. That is to say, the body may be placed directly on top of the base.

In the above embodiments, an example is given where six casters 23 are provided and where casters 23 are disposed at the vertices of a virtual, regular hexagon. However, casters 23 may be provided in any number and/or layout that satisfies standardized tipping angles. A tipping angle is the degree of titling of a device in relation to the vertical direction and serves as an index used for preventing the device from tipping over when the device is tilted at an angle that does not exceed the tipping angle. For example, there are cases where tipping angles have been standardized to be dependent on device size (height), and in such cases, the appropriate number and/or layout of casters 23 disposed are determined based on device size.

Hereinafter, other layouts for first casters 231 and second casters 232 will be described. FIG. 6 is a diagram for describing layout examples of first casters 231 and second casters 232 according to variations.

(a) in FIG. 6 illustrates a layout example where only one first caster 231 is provided. In (a) in FIG. 6, first caster 231 is disposed at the central portion of base 22, and second casters 232 are evenly arranged on the periphery of base 22. Since the single first caster 231 disposed at the central portion bears a large amount of load, creep deformation of each second caster 232 having low hardness can be inhibited. Furthermore, since the minimum number of first casters 231 is provided, rolling noise caused by first casters 231 can be suppressed.

(b) in FIG. 6 illustrates a layout example where the total number of casters 23 is a number other than six. (b) in FIG. 6 illustrates a case where four casters 23 are disposed in a square-shaped arrangement, and, out of the four casters, two first casters 231 are arranged in a direction parallel to display surface 111 of body 10, in positions that overlap body 10 in a plan view of base 22.

(c) in FIG. 6 illustrates a layout example where three first casters 231 are provided. Of the three first casters 231, two first casters 231 are arranged in a direction parallel to display surface 111 of body 10, in positions that overlap body 10 in a plan view of base 22. The remaining first caster 231 is disposed at a position in front of (or behind) an imaginary line connecting the two first casters 231. In this case, since the three first casters 231 form a plane to support the deadweight of display device 100, load applied to each second caster 232 can further be reduced. Consequently, deformation of each second caster 232 can further be inhibited.

Furthermore, the above-mentioned embodiments illustrate examples where a plurality of recessed portions 222 that house respective casters 23 are provided on the bottom surface of base body 221. However, it should be noted that the bottom surface of base body 221 may be entirely flat, and each caster 23 may be disposed on this flat bottom surface.

Furthermore, although the above-mentioned embodiments illustrate examples where base body 221 is of a circular board shape, the base body may be of any kind of external shape. For example, other possible external shapes for the base body include various elliptical boards, polygonal boards, and the like.

Although the above-mentioned embodiments illustrate examples where casters 23 are swiveling casters, any kind of casters that can roll on a floor surface may be used. Other possible casters include non-swiveling casters. Specifically, in such casters, the support component is fixed to or integrated with the base plate so as to not swivel. In such cases, the wheels are attached to the base to face a direction that enables stand 20 to be moved in a direction parallel to display surface 111 by rolling the wheels on a floor surface. That is to say, the wheels are attached to the base so that the axles of the wheels are facing a direction that is orthogonal to display surface 111.

Other examples of casters include casters that have an axle supported by a support component in a cantilever arrangement. Specifically, only one end of the axle of the wheel is supported by the support component to freely rotate.

Other examples of casters include casters having one support component that supports two wheels. Specifically, the two wheels are supported at both ends of an axle, and the support component supports the central portion of the axle. When such casters are used as first casters and second casters, second casters should have low hardness for both wheels, and first casters should have at least one of the wheels having a hardness higher than the hardness of the second casters.

Other examples of casters include casters having spherical wheels. Specifically, such a spherical wheel is supported to rotate freely by a support component that includes a ball housing. In this case, since the spherical wheel rotates in any direction, the stand can be moved in any direction.

In these examples, the same type of casters or different types of casters may be used for the first casters and second casters. In either case, by making the hardness of the second casters lower than the hardness of the first casters, the effects of the present disclosure can be obtained.

Additionally, forms obtained by various modifications to the embodiments and variations conceivable by those skilled in the art, as well as forms resulting from arbitrary combinations of elements and functions in the embodiments that do not depart from the essence of the present invention are intended to be included in the scope of the present invention.

### [Industrial Applicability]

The present invention is widely applicable to, for example, display devices and stands that include casters.

### [Reference Signs List]

- 10: body
- 15: power cable
- 20: stand
- 21: column
- 22: base
- 23: caster
- 24: wheel
- 25: support component
- 26: base plate
- 99: carpet
- 100, 100A: display device
- 111: display surface
- 200: tuner device
- 221: base body
- 222: recessed portion
- 222a, 222b: recessed portion
- 229: storage section
- 231: first caster
- 232: second caster
- 300A: stand
- 310a: restricting component
- 311: positioning tab
- P: center of gravity
- Y1: path of travel

## Claims

1. A display device comprising:
a body that displays an image; and
a base that supports the body in a state where the base is placed on a floor surface, wherein
the base includes a plurality of casters that roll on the floor surface, and
the plurality of casters include at least one first caster and at least one second caster having a hardness lower than a hardness of the at least one first caster.

2. The display device according to claim 1, wherein
the plurality of casters are arranged in a circumferential direction on the base,
the at least one first caster comprises two first casters, and
the two first casters are arranged in a direction parallel to a display surface of the body, in positions that overlap the body in a plan view of the base.

3. The display device according to claim 1 or 2, wherein
the base is disposed in a position that overlaps a center of gravity of the body in a plan view of the base, and
both side portions of the body protrude beyond the base in the plan view of the base.

4. The display device according to any one of claims 1 to 3, further comprising:
a column that stands from the base and supports the body.

5. A stand that supports a display device, the stand comprising:
a base that holds the display device in a state where the base is placed on a floor surface, wherein
the base includes a plurality of casters that roll on the floor surface, and
the plurality of casters include at least one first caster and at least one second caster having a hardness lower than a hardness of the at least one first caster.

6. The stand according to claim 5, comprising:
a restricting component that restricts a position of the display device, wherein
the plurality of casters are arranged in a circumferential direction on the base,
the at least one first caster comprises two first casters, and
the restricting component restricts the position of the display device to keep the two first casters arranged in a direction parallel to a display surface of the display device, in positions that overlap the display device in a plan view of the base.
